(19) Europäisches Patentamt
European Patent Office
Office européen des brevets

(11) Numéro de publication: **0 048 189**
**B1**

# (12) FASCICULE DE BREVET EUROPEEN

(45) Date de publication du fascicule du brevet: **28.03.84**

(51) Int. Cl.[3]: **H 03 B 5/18**

(21) Numéro de dépôt: **81401308.2**

(22) Date de dépôt: **14.08.81**

(54) **Oscillateur à transistor comportant un résonateur diélectrique qui lui confère une stabilité maximale et un bruit minimal en très haute fréquence.**

(30) Priorité: **16.09.80 FR 8019917**

(43) Date de publication de la demande:
**24.03.82 Bulletin 82/12**

(45) Mention de la délivrance du brevet:
**28.03.84 Bulletin 84/13**

(84) Etats contractants désignés:
**DE GB NL**

(56) *Documents cités:*
**IEEE TRANSACTIONS ON MICROWAVE THEORY AND TECHNIQUES, vol. MTT 28, no. 8, août 1980 New York, US O. ISHIHARA et al.: "A Highly Stabilized GaAs FET Oscillator Using a Dielectric Resonator Feedback Circuit in 9-14 GHz", pages 817-824**
**1979 IEEE MTTS, INTERNATIONAL MICROWAVE SYMPOSIUM DIGEST New York, US T. SAITO et al.: "A 6 GHz Highly Stabilized GaAs FET Oscillator Using a Dielectric Resonator", pages 197-199**
**IEEE TRANSACTIONS ON MICROWAVE THEORY AND TECHNIQUES, vol. MTT 27, no. 12, décembre 1979 New York, US G.D. ALLEY "An Ultra-Low Noise Microwave Synthesizer", pages 969-974**

(73) Titulaire: **THOMSON-CSF, 173, Boulevard Haussmann, F-75379 Paris Cedex 08 (FR)**

(72) Inventeur: **Godart, Jean-Jacques, THOMSON-CSF SCPI 173, bld Haussmann, F-75360 Paris Cedex 08 (FR)**
Inventeur: **Leclerc, Bernard, THOMSON-CSF SCPI 173, bld Haussmann, F-75360 Paris Cedex 08 (FR)**

(74) Mandataire: **Wang, Pierre et al, THOMSON-CSF SCPI 173, Bld Haussmann, F-75379 Paris Cedex 08 (FR)**

**EP 0 048 189 B1**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

Oscillateur à transistor comportant un résonateur diélectrique qui lui confère une stabilité maximale et un bruit minimal en très haute fréquence

L'invention concerne les oscillateurs à transistors en très haute fréquence (au-dessus du GHz).

On connaît des oscillateurs à diode Gunn fonctionnant dans la bande de 3 à 10 GHz avec une très grande stabilité obtenue grâce à l'utilisation d'un résonateur diélectrique à très faible coefficient de température, couplé à la diode Gunn. Leur puissance est toutefois limitée à quelques dizaines de milliwatts.

On connaît d'autre part des oscillateurs à transistors fonctionnant dans la même bande de fréquences, avec une stabilité du même ordre obtenue grâce à l'utilisation du même type de résonateur. Un oscillateur de ce type a été décrit dans un article de O. Ishihara *et al.*, paru dans la revue «IEEE Transactions on microwave theory and techniques», vol. MTT-28, N° 8, août 1980, pp. 817-824, sous le titre «A highly stabilized Ga As FET oscillator using a dielectric resonator feedback circuit in 9-14 GHz». Cet article décrit un oscillateur à faible bruit mais dont la puissance de sortie (70 mW) est pratiquement du même ordre de grandeur que celle délivrée par les oscillateurs à diode Gunn. On peut également citer un oscillateur décrit par G.D. Alley dans la revue «IEEE Transactions on microwave theory and techniques», vol. MTT-27, N° 12, décembre 1979, sous le titre «An ultra-low noise microwave synthesizer». Cet oscillateur présente un très faible bruit mais pour une fréquence de fonctionnement de 1 GHz et pour une puissance de sortie de quelques dizaines de milliwatts. D'autres oscillateurs à transistors permettent d'obtenir des puissances de sortie qui peuvent atteindre et même dépasser le watt. Toutefois, leur bruit en haute fréquence est beaucoup plus important que dans le cas des oscillateurs à diode Gunn.

L'invention vise à réduire cet inconvénient, tout en bénéficiant de la puissance importante de ce dernier type d'oscillateurs, lequel peut aussi bien comporter un transistor à effet de champ qu'un transistor bipolaire.

L'oscillateur à transistor selon l'invention, du type conçu pour fonctionner sur une fréquence prédéterminée, comporte un élément actif dont la grille, dans le cas d'un transistor à effet de champ, ou la base, dans le cas d'un transistor bipolaire, est reliée à une première ligne microbande d'impédance caractéristique donnée, de longueur électrique supérieure au quart de la longueur d'onde, couplée au voisinage d'un point prédéterminé de cette ligne à un résonateur diélectrique accordé sur ladite fréquence, cette ligne étant connectée, à son extrémité située du côté opposé au transistor, à une extrémité d'une résistance ohmique égale au module de l'impédance caractéristique de ladite ligne, l'autre extrémité de ladite résistance étant reliée à un circuit résonnant constitué par une seconde ligne microbande demi-onde pour ladite fréquence et terminée en circuit ouvert.

L'invention sera mieux comprise et d'autres caractéristiques apparaîtront au moyen de la description qui suit et des dessins qui l'accompagnent, dans lesquels:

la fig. 1 est un schéma électrique d'un oscillateur selon l'invention;

la fig. 2 représente en perspective cavalière la partie de l'oscillateur montée sur ligne de type microbande;

les fig. 3 et 4 sont des diagrammes explicatifs.

Sur la fig. 1, on a représenté schématiquement un oscillateur équipé d'un transistor figuré suivant le symbole des transistors à effet de champ, qui peut être soit un transistor à effet de champ, soit un transistor bipolaire.

Ce transistor peut être nu ou en boîtier. On a désigné par un repère 1 l'électrode de ce transistor qui est à la masse du boîtier et qui peut être, suivant le cas, la source d'un transistor à effet de champ, le collecteur d'un bipolaire de type npn ou l'émetteur d'un bipolaire de type pnp.

L'électrode 2 du transistor est la grille ou la base, selon le cas. L'électrode 3 est la troisième électrode du transistor.

Sur la même figure, le transistor est alimenté à travers une inductance 4 par une tension continue −V, c'est-à-dire une tension négative, dans le cas d'un transistor à effet de champ de canal n. Cela a pour effet de permuter source et drain et de faciliter le fonctionnement en oscillateur, grâce à la capacité source-grille (plus grande que la capacité grille-drain par construction du transistor normal).

En outre, l'électrode 2 est reliée à une extrémité d'un conducteur 5 constituant un premier élement de ligne microbande de longueur $L_1$, élément qui est relié à travers une résistance R du type discret à un conducteur 6 de longueur $L_2$, qui constitue un deuxième élément de ligne microbande.

Un résonateur diélectrique 8 est placé au voisinage de l'élément 5. Il est constitué par un tronçon cylindrique 8 en céramique à forte constante diélectrique relative (35 à 40), à faibles pertes et à faible coefficient de dilatation en fonction de la température, de formule générale:

$$Zr_xSn_{1-x}TiO_4$$

dans laquelle x est compris entre 0,2 et 0,4.

Un plan diamétral du cylindre 8, perpendiculaire à l'élément 5 et de trace AA sur le plan de la fig. 1, divise l'élément 5 en deux parties, l'une de longueur L' du côté du transistor, l'autre étant égale au quart de la longueur d'onde dans le diélectrique de la ligne microbande.

Enfin, un troisième élément 7 de ligne microbande est branché à l'électrode par l'une de ses extrémités, l'autre étant reliée à la masse à travers la charge de l'oscillateur représentée par une résistance ohmique 9.

Pour obtenir un fonctionnement très stable à une fréquence F, avec le bruit minimal autour de cette fréquence, on prend les dispositions ci-après.

1. On dimensionne le cylindre 8 dans le matériau indiqué plus haut de telle sorte qu'il

résonne à la fréquence F (par exemple diamètre de 7,8 mm et hauteur de 3,9 mm dans le cas de F = 8 GHz).

2. On réalise l'élément 6 de ligne microbande pour avoir:

$$L_2 = \lambda/2$$

la longueur d'onde correspondant à la fréquence F se propageant dans le diélectrique de la ligne microbande.

3. Soit $Z_{AA}$ l'impédance (vue en AA du côté opposé au transistor) du circuit comprenant la ligne 6, la résistance R et le tronçon quart d'onde de la ligne 5, couplé au résonateur 8, si $Z_o$ désigne l'impédance caractéristique de la ligne 5 et $\beta$ le coefficient de couplage du résonateur 8 à cette ligne, on a:

$$Z_{AA} = \beta Z_o$$

à la fréquence F de résonance du résonateur 8. Elle correspond sensiblement à un circuit ouvert pour un grand coefficient de couplage. Par contre, dès qu'on s'éloigne de la résonance, $Z_{AA}$ correspond sensiblement à un court-circuit, en raison du grand coefficient de surtension du résonateur.

Partant des paramètres S du transistor, on règle la longueur L' de sorte que le module du coefficient de réflexion ($S'_{22}$) calculé à la sortie du transistor, sur l'électrode 3, l'entrée 2 du transistor étant chargée par une ligne en circuit ouvert de longueur L', soit maximal.

4. On ajuste la distance entre le résonateur 8 et la ligne 5, c'est-à-dire le coefficient de couplage, de sorte que la résistance négative présentée par le transistor sur sa sortie 3 soit supérieure en valeur absolue à la partie réelle de la charge 9 vue à travers la ligne d'adaptation 7.

5. La présence de la résistance R, chargée par la ligne demi-onde 6, permet d'amortir l'oscillateur en dehors de la fréquence d'oscillation, ce qui produit une réduction très importante du bruit dit de fréquence.

Sur la fig. 2, où les mêmes repères désignent des éléments identiques ou analogues, on a représenté une réalisation de l'invention. Un substrat 21 en silice présente la forme d'un parallélépipède rectangle à deux grandes faces planes rectangulaires de forme très allongée, l'épaisseur du substrat étant de 0,5 à 0,8 mm. La face inférieure est revêtue d'une couche métallique 22 constituant un plan de masse. Sur la face supérieure ont été déposées des bandes ou dépôts conducteurs 5, 6 et 7 représentant les éléments de ligne microbande de la fig. 1. Leur largeur est calculée de manière à donner à la ligne une impédance caractéristique de 50 Ω (1 à 1,7 mm dans l'exemple choisi). En outre, le substrat comporte une ouverture 23 pratiquée dans la silice jusqu'à démasquer le plan de masse, et partiellement remplie éventuellement par un dépôt de cuivre, où l'on a monté le transistor T dont l'électrode 1 (non vue) est soudée à la masse. La résistance R est par exemple un parallélépipède rectangle de silicium convenablement dopé pour que l'on ait entre les points de connexion de cette résistance une valeur ohmique de 50 Ω.

La fig. 3 donne un exemple des résultats obtenus avec un transistor à effet de champ de référence commerciale MSC 88004 pour lequel la longueur L' optimale est de 0,236 λ.

On a porté en abscisses la tension V en volts, et en ordonnées, suivant trois échelles distinctes, la puissance P en mW, la fréquence F en MHz et le rendement η en %.

La puissance haute fréquence P est de l'ordre de 400 mW pour V = 9 volts.

La fréquence varie très peu malgré les apparences, dues à une échelle très dilatée, lorsque V varie de 3 à 9 volts. Aux environs de 7 volts, le coefficient de variation de la fréquence d'oscillation est de 50 kHz/volts.

Le rendement est maximal entre 7 et 9 volts.

La fig. 4 donne le niveau de bruit −P' exprimé en dB/kHz en échelle inversée, en fonction de la largeur de bande en kHz (F) pour trois oscillateurs:

– un oscillateur selon l'invention (courbe 41) avec F = 8 GHz et P = 200 mW;

– un oscillateur analogue (courbe 42) avec F = 8 GHz mais P = 400 mW;

– un oscillateur à diode Gunn (courbe 43) avec F = 9 GHz et P = 20 mW.

Dans le cas de l'invention, on voit que le bruit est du même ordre que dans le cas de l'oscillateur à diode Gunn, mais avec une puissance 10 à 20 fois plus grande.

## Revendications

1. Oscillateur à transistor du type à effet de champ conçu pour fonctionner sur une fréquence prédéterminée, comportant un élément actif dont la grille est reliée à une première ligne microbande (5) d'impédance caractéristique donnée, de longueur électrique supérieure au quart de la longueur d'onde, couplée au voisinage d'un point prédéterminé de cette ligne à un résonateur diélectrique (8) accordé sur ladite fréquence, cette ligne étant connectée, à son extrémité située du côté opposé au transistor, à une extrémité d'une résistance ohmique R égale au module de l'impédance caractéristique de ladite ligne, ledit oscillateur étant caractérisé en ce que l'autre extrémité de ladite résistance est reliée à un circuit résonnant constitué par une seconde ligne microbande (6) demi-onde pour ladite fréquence et terminée en circuit ouvert.

2. Oscillateur à transistor du type bipolaire, conçu pour fonctionner sur une fréquence prédéterminée, comportant un élément actif dont la base est reliée à une première ligne microbande (5) d'impédance caractéristique donnée, de longueur électrique supérieure au quart de la longueur d'onde, couplée au voisinage d'un point prédéterminé de cette ligne à un résonateur diélectrique (8) accordé sur ladite fréquence, cette ligne étant connectée, à son extrémité située du côté opposé au transistor, à une extrémité d'une résistance ohmique R égale au module de l'impédance caractéristique de ladite ligne, ledit oscillateur étant caractérisé en ce que l'autre extrémité de

ladite résistance est reliée à un circuit résonnant constitué par une seconde ligne microbande (6) demi-onde pour ladite fréquence et terminée en circuit ouvert.

3. Oscillateur selon l'une des revendications 1 ou 2, caractérisé en ce que le résonateur est réalisé en matériau céramique de formule:

$$Zr_xSn_{1-x}TiO_4$$

où x est compris entre 0,2 et 0,4.

4. Oscillateur selon l'une des revendications 1 ou 2, caractérisé en ce que lesdites lignes microbandes sont réalisées sur un substrat (21) en silice.

## Patentansprüche

1. Feldeffekttransistor-Oszillator, der bei einer vorgegebenen Frequenz schwingen soll und ein aktives Element aufweist, dessen Torelektrode mit einer ersten Mikrostreifenleitung (5) einer gegebenen charakteristischen Impedanz und einer elektrisch wirksamen Länge verbunden ist, die grösser als eine Viertelwellenlänge ist, wobei diese Leitung in der Nähe eines vorbestimmten Punktes der Leitung mit einem auf die genannte Frequenz abgestimmten dielektrischen Resonator (8) gekoppelt ist und mit ihrem dem Transistor abgewandten Ende an ein Ende eines ohmschen Widerstands R angeschlossen ist, der dem Modul der charakteristischen Impedanz der Leitung gleicht, dadurch gekennzeichnet, dass das andere Ende dieses Widerstands an einen von einer zweiten Mikrostreifenleitung (6) gebildeten Schwingkreis angeschlossen ist, dessen wirksame Länge der halben Wellenlänge für die gegebene Frequenz entspricht und der in einem offenen Kreis endet.

2. Einen bipolaren Transistor enthaltender Oszillator, der bei einer vorgegebenen Frequenz schwingen soll und ein aktives Element aufweist, dessen Basiselektrode mit einer ersten Mikrostreifenleitung (5) einer gegebenen charakteristischen Impedanz und einer elektrisch wirksamen Länge verbunden ist, die grösser als eine Viertelwellenlänge ist, wobei diese Leitung in der Nähe eines vorbestimmten Punktes der Leitung mit einem auf die genannte Frequenz abgestimmten dielektrischen Resonator (8) gekoppelt ist und mit ihrem dem Transistor abgewandten Ende an ein Ende eines ohmschen Widerstands R angeschlossen ist, der dem Modul der charakteristischen Impedanz der Leitung gleicht, dadurch gekennzeichnet, dass das andere Ende dieses Widerstands an einen von einer zweiten Mikrostreifenleitung (6) gebildeten Schwingkreis angeschlossen ist, dessen wirksame Länge der halben Wellenlänge für die gegebene Frequenz entspricht und der in einem offenen Kreis endet.

3. Oszillator nach einem der Ansprüche 1 oder 2, dadurch gekennzeichnet, dass der Resonator aus einem keramischen Material der Formel:

$$Zr_x Sn_{1-x} TiO_4$$

besteht, in der x zwischen 0,2 und 0,4 liegt.

4. Oszillator nach einem der Ansprüche 1 oder 2, dadurch gekennzeichnet, dass die Mikrostreifenleitungen auf einem Kieselerdesubstrat (21) aufgebracht sind.

## Claims

1. A FET-oscillator conceived to operate at a predetermined frequency, an active element being provided the gate of which is connected to a first microstrip line (5) of a given characteristical impedance and of an electrical length which exceeds a quarter wave length, this line being coupled close to a predetermined point of said line to a dielectric resonator (8) which is matched to said frequency, and being connected by its terminal which is situated away from the transistor to a terminal of an ohmic resistor R, the value of which is equal to the module of the characteristical impedance of said line, characterized in that the other resistor terminal is connected to a resonant circuit constituted by a second microstrip line (6), the length of which corresponds to half a wave at the predetermined frequency and which is not terminated.

2. An oscillator comprising a bipolar transistor and conceived to operate at a predetermined frequency, an active element being provided the base of which is connected to a first microstrip line (5) of a given characteristical impedance and of an electrical length which exceeds a quarter wave length, this line being coupled close to a predetermined point of said line to a dielectric resonator (8) which is matched to said frequency, and being connected by its terminal which is situated away from the transistor to a terminal of an ohmic resistor R the value of which is equal to the module of the characteristical impedance of said line, characterized in that the other resistor terminal is connected to a resonant circuit constituted by a second microstrip line (6) the length of which corresponds to half a wave at the predetermined frequency and which is not terminated.

3. An oscillator according to one of the claims 1 or 2, characterized in that the resonator is made of a ceramic material having the formula:

$$Zr_x Sn_{1-x} TiO_4$$

in which x lies between 0,2 and 0,4.

4. An oscillator according to one of the claims 1 or 2, characterized in that the said microstrip lines are realised on a silica substrate (21).

FIG.1

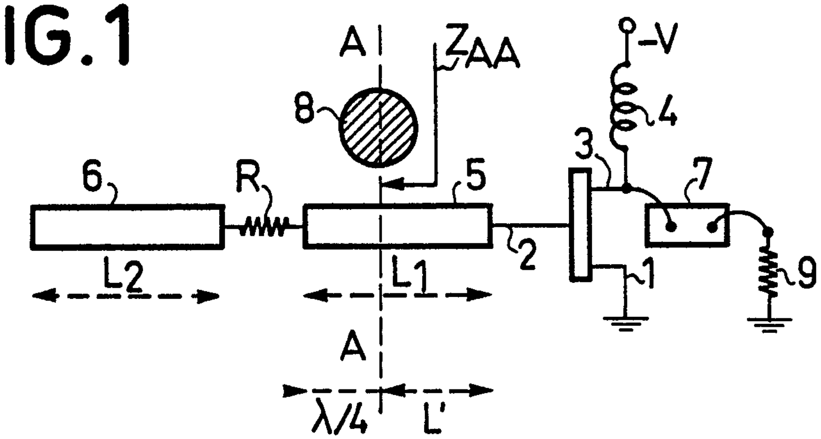


FIG.2

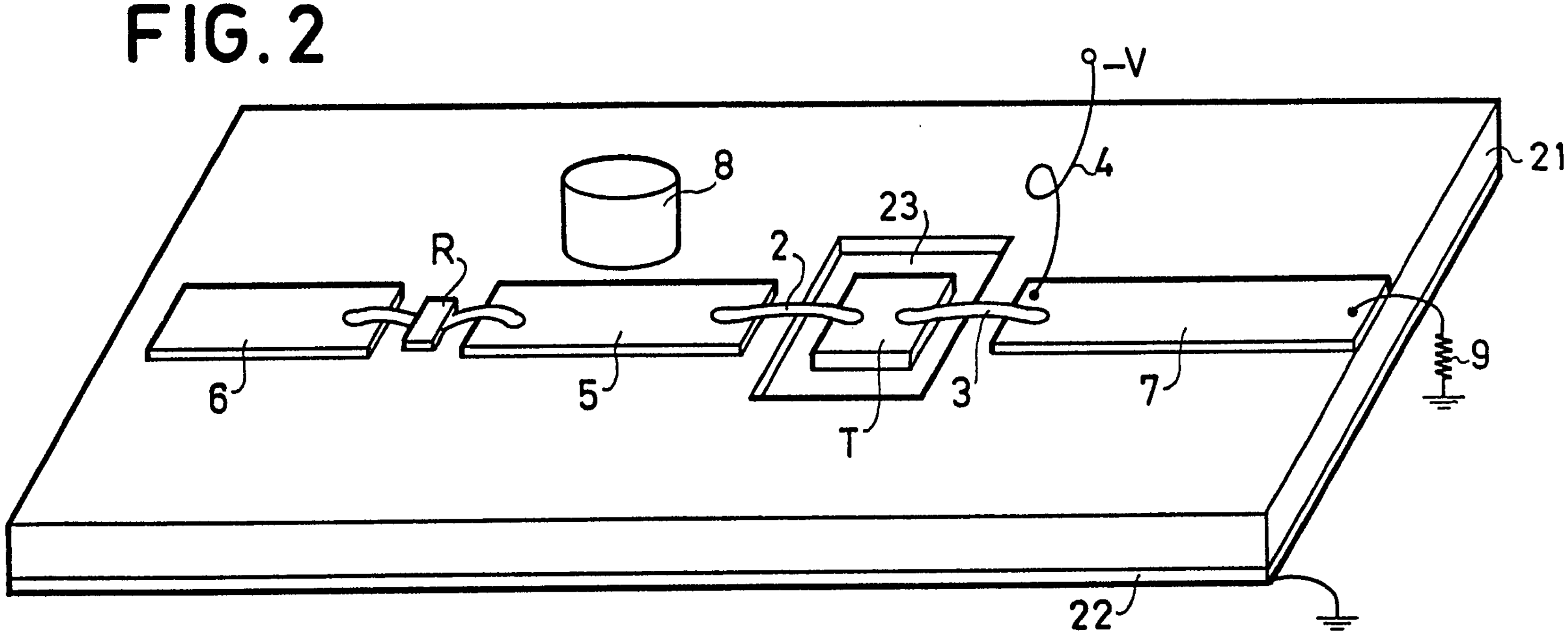

FIG.3

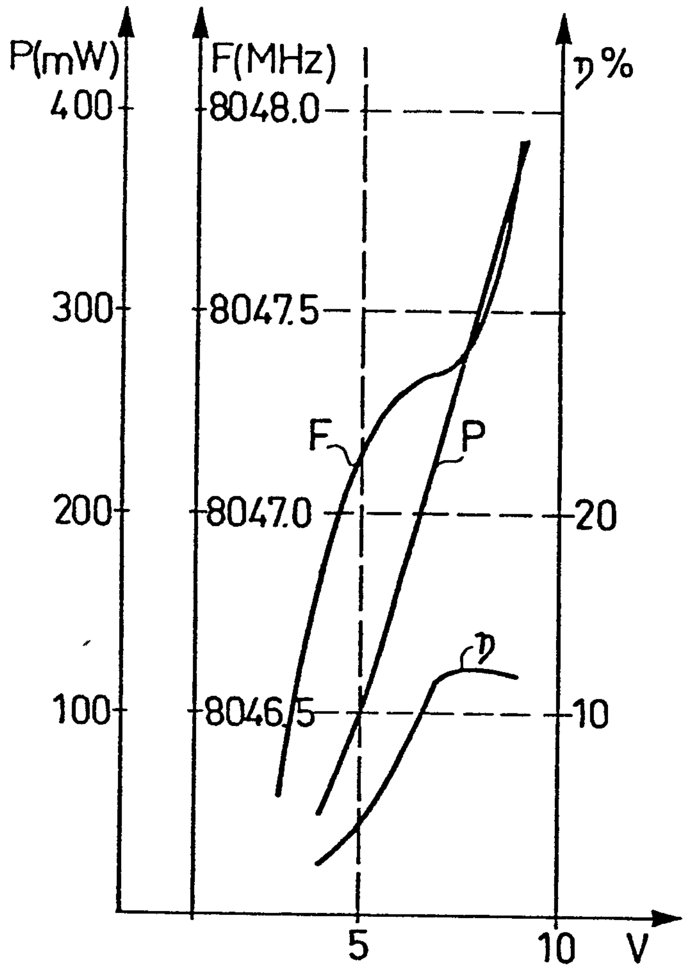
P(mW)
F(MHz)
η %
400
300
200
100
8048.0
8047.5
8047.0
8046.5
20
10
F
P
η
5
10
V

FIG.4

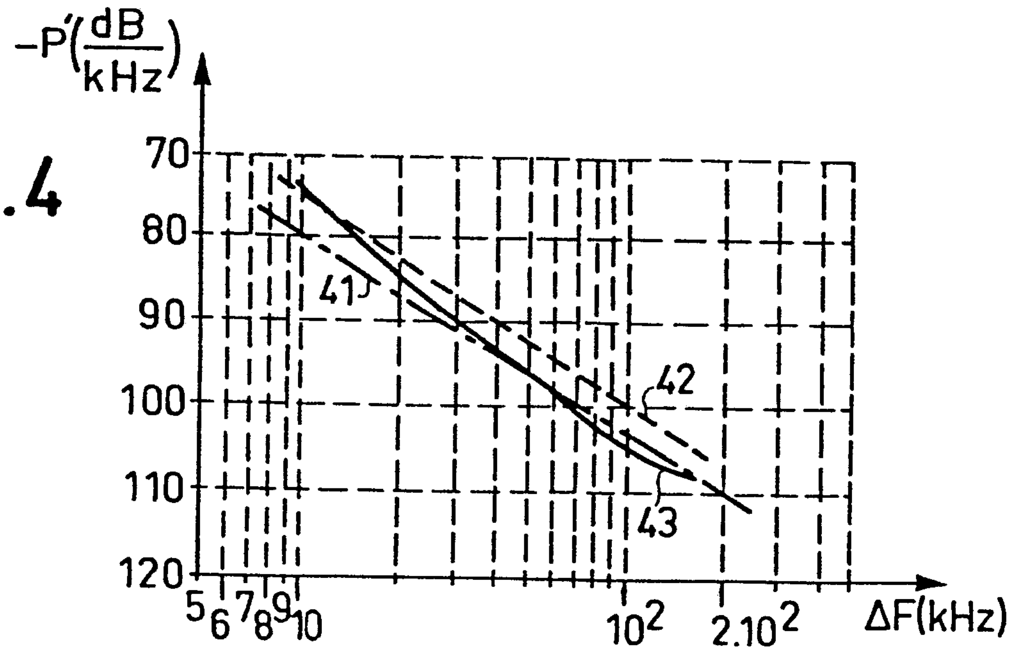
-P'(dB/kHz)
70
80
90
100
110
120
41
42
43
5 6 7 8 9 10
10^2
2.10^2
ΔF(kHz)